# EUROPÄISCHE PATENTANMELDUNG

(11) **EP 0 776 043 A2**
(43) Veröffentlichungstag der Anmeldung: **28.05.1997**
(21) Anmeldenummer: 96810749.0
(22) Anmeldetag: 07.11.1996
(51) Int. Cl.: H01L 25/18, H01L 25/07

(54) **Leistungshalbleitermodul-System**

(30) Priorität: 24.11.1995 US 562453
(71) Anmelder: ASEA BROWN BOVERI AG, 5400 Baden (CH)
(72) Erfinder: Bayerer, Reinhold, Dr., 64385 Reichelsheim (DE)
(74) Vertreter: Weibel, Beat

(57) **Zusammenfassung**

Ein Leistungshalbleitermodul-System umfasst eine Mehrzahl von Typen von Leistungshalbleitermodulen (310), welche jeweils einen oder mehrere steuerbare Leistungshalbleiter (36, 37) enthalten und jeweils in einem Modulgehäuse (311) mit nach aussen geführten Leistungsanschlüssen (313-317) und Steueranschlüssen untergebracht sind, sowie zu jedem der Leistungshalbleitermodule (310) eine in einem separaten Gehäuse (334) untergebrachte Ansteuereinheit (325), welche mit dem zugehörigen Leistungshalbleitermodul derart lösbar verbunden werden kann, dass die von der Ansteuereinheit (325) an entsprechenden Steuersignalausgängen abgegebenen Ansteuersignale auf die entsprechenden Steueranschlüsse des Leistungshalbleitermoduls gelangen, wobei die Steueranschlüsse der Leistungshalbleitermodule (310) jeweils in einer ersten ortsfesten räumlichen Konfiguration angeordnet sind, und die Steuersignalausgänge der Ansteuereinheiten (325) jeweils in einer zweiten ortsfesten räumlichen Konfiguration angeordnet sind, die zur ersten Konfiguration deckungsgleich ist.

Bei einem solchem Modulsystem wird ansteuerseitig eine Reduzierung des Aufwands für Lagerhaltung und Installation dadurch erreicht, dass die ersten und zweiten Konfigurationen für alle Leistungshalbleitermodule (310) bzw. Ansteuereinheiten (325) gleich sind, und dass sich die verschiedenen Leistungshalbleitermodule (310) bzw. Ansteuereinheiten (325) durch eine unterschiedliche Belegung der Steueranschlüsse bzw. Steuersignalausgänge unterscheiden.

## Beschreibung

### TECHNISCHES GEBIET

Die vorliegende Erfindung bezieht sich auf das Gebiet der Leistungselektronik. Sie betrifft ein Leistungshalbleitermodul-System, umfassend eine Mehrzahl von Typen von Leistungshalbleitermodulen, welche jeweils einen oder mehrere steuerbare Leistungshalbleiter enthalten und jeweils in einem Modulgehäuse mit nach aussen geführten Leistungsanschlüssen und Steueranschlüssen untergebracht sind, sowie zu jedem der Leistungshalbleitermodule eine in einem separaten Gehäuse untergebrachte Ansteuereinheit, welche mit dem zugehörigen Leistungshalbleitermodul derart lösbar verbunden werden kann, dass die von der Ansteuereinheit an entsprechenden Steuersignalausgängen abgegebenen Ansteuersignale auf die entsprechenden Steueranschlüsse des Leistungshalbleitermoduls gelangen, wobei die Steueranschlüsse der Leistungshalbleitermodule jeweils in einer ersten ortsfesten räumlichen Konfiguration angeordnet sind, und die Steuersignalausgänge der Ansteuereinheiten jeweils in einer zweiten ortsfesten räumlichen Konfiguration angeordnet sind, die zur ersten Konfiguration deckungsgleich ist.

### STAND DER TECHNIK

Hochleistungs-IGBT-Module für Anwendungen in der Traktion (elektr. Lokomotiven etc.), die in einem Modulgehäuse untergebracht sind und zur Ansteuerung mit einem separaten Gate-Ansteuermodul verbunden bzw. verschraubt werden können, sind vom Erfinder bereits in dem Artikel von T. Stockmeier et al. "Reliable 1200 Amp 2500 V IGBT Modules for Traction Applications", IEE IGBT Propulsion Drives Colloquium, London, 25. April 1995, vorgestellt worden. Die aufeinander abgestimmten Konfigurationen der Steueranschlüsse am Leistungshalbleitermodul und der Steuersignalausgänge an der Ansteuereinheit ermöglichen es, dass die Ansteuereinheit mit ihrem Gehäuse einfach auf das Modulgehäuse des Leistungshalbleitermoduls aufgesetzt und festgeschraubt werden kann, wobei die notwendigen elektrischen Verbindungen zwischen Ansteuereinheit und Leistungshalbleitermodul durch einfache Schraubanschlüsse hergestellt werden.

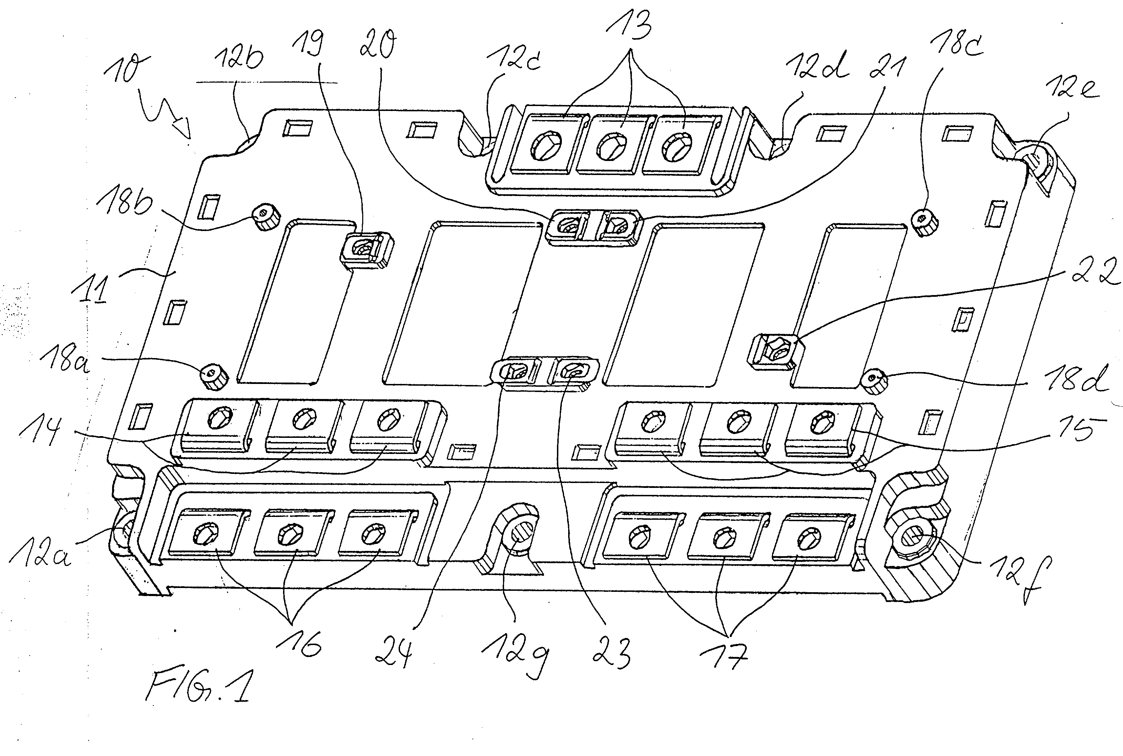

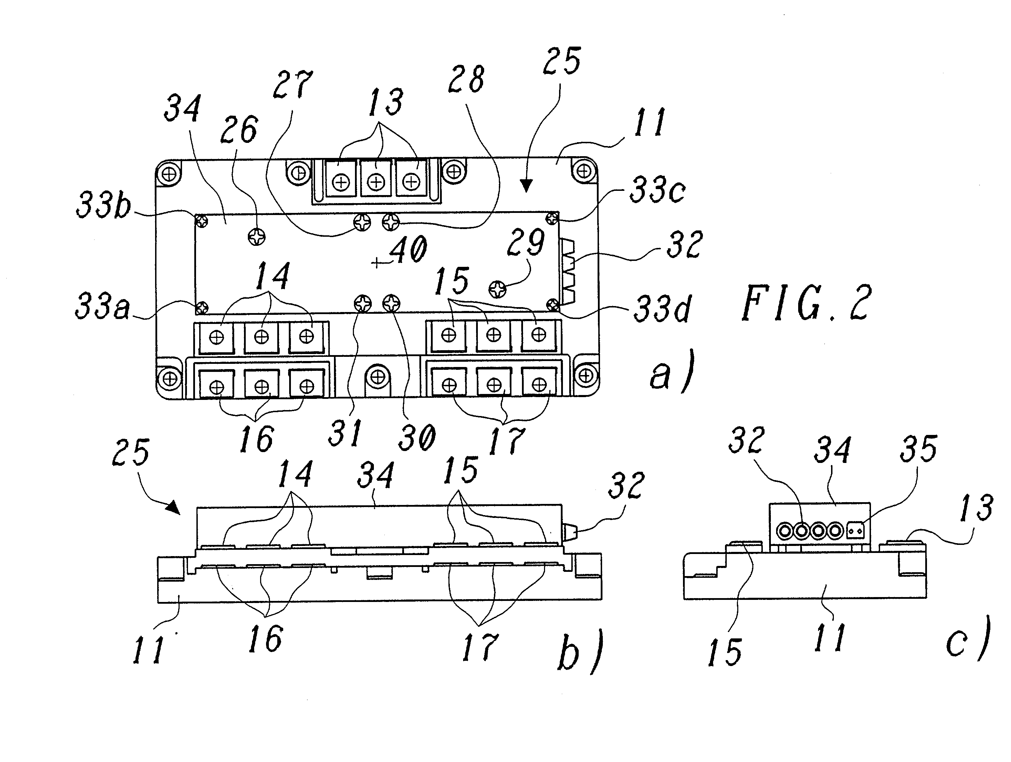

In diesem Artikel wird auch darauf verwiesen, dass neben dem dort beschriebenen 1200 A/2500 V-Modul mit einem einzelnen Leistungshalbleiter (der eigentlich aus einer Mehrzahl von parallel geschalteten kleineren IGBTs besteht und zusätzlich noch mit einer antiparallelen Diode verschaltet ist) auch Halbbrücken-Module mit zwei unabhängig ansteuerbaren Leistungshalbleitern oder vollständige 3-Phasen-Brücken-Module mit 6 Leistungshalbleitern vorgesehen sind. Alle Module sollen dabei denselben "footprint" aufweisen, d.h. von den Abmessungen und Befestigungsmöglichkeiten her austauschbar sein. Die Bauform der bekannten Module und der zugehörigen Ansteuereinheiten ist im übrigen vergleichbar mit den Darstellungen in Fig. 1 und 2.

Die Verwendung einer einheitlichen Bauform für verschiedene Module mit unterschiedlichem internen Aufbau (Einzelschalter, Halbbrücke, Vollbrücke etc.) führt im Stand der Technik bereits zu einer Normierung hinsichtlich des Aufbaus von Brückenschaltungen und dgl., die den Installationsaufwand verringert und die Lagerhaltung (von Anschlussteilen, aufsetzbaren Kühler etc.) vereinfacht. Probleme ergeben sich jedoch auf der Ansteuerseite, weil jedes Modul je nach innerem Aufbau eine andere Art der Ansteuerung benötigt. Beim Modul mit Einzelhalbleiter muss beispielsweise nur ein Gate angesteuert werden, beim Modul mit Halbbrücke dagegen zwei. Darüber hinaus können die Module mit Einzelhalbleiter noch in zwei unterschiedlichen Ausführungen vorhanden sein, je nachdem, ob sie den oberen oder unteren Teil einer Halbbrücke bilden sollen.

### DARSTELLUNG DER ERFINDUNG

Es ist nun Aufgabe der Erfindung, ein System von Leistungshalbleitermodulen zu schaffen, bei dem ansteuerseitig eine Reduzierung des Aufwands für Lagerhaltung und Installation erreicht werden kann.

Die Aufgabe wird bei einem Leistungshalbleitermodul-System der eingangs genannten Art dadurch gelöst, dass die ersten und zweiten Konfigurationen für alle Leistungshalbleitermodule bzw. Ansteuereinheiten gleich sind, und dass sich die verschiedenen Leistungshalbleitermodule bzw. Ansteuereinheiten durch eine unterschiedliche Belegung der Steueranschlüsse bzw. Steuersignalausgänge unterscheiden. Durch die ansteuerseitige Normierung der Anschlusskonfiguration ist es möglich, durch unterschiedlichem internen Aufbau von Leistungshalbleitermodul und Ansteuereinheit unterschiedliche Teile von Leistungshalbleiter-Brücken zu realisieren, ohne auf die Vorteile einer einheitlichen Anschlusstechnik verzichten zu müssen. Die einheitliche Anschlusskonfiguration bringt für sich genommen bereits eine erhebliche Vereinfachung, unabhängig davon, ob die verschiedenen Leistungshalbleitermodule sonst in einer einheitlichen Bauform vorliegen oder nicht.

Eine erste bevorzugte Ausführungsform des erfindungsgemässen Systems zeichnet sich dadurch aus, dass die Modulgehäuse und die Gehäuse der Ansteuereinheiten jeweils für alle Leistungshalbleitermodule bzw. Ansteuereinheiten gleich sind, dass die Leistungsanschlüsse der Leistungshalbleitermodule jeweils in einer dritten ortsfesten räumlichen Konfiguration angeordnet sind, dass die dritte Konfiguration für alle Leistungshalbleitermodule gleich ist, und dass sich die verschiedenen Leistungshalbleitermodule durch eine unterschiedliche Belegung der Leistungsanschlüsse unterscheiden. Durch die über die Ansteuerseite hinausgehende Normierung der Module und Ansteuereinheiten ergibt sich eine noch weitergehende Vereinfachung.

Besonders günstig ist das System in der Anwendung, wenn gemäss einer zweiten bevorzugten Ausführungsform das System wenigstens drei Typen von Leistungshalbleitermodulen umfasst, welche insbesondere zum Aufbau von Brückenschaltungen geeignet sind, wobei der erste Typ ein Leistungshalbleitermodul mit einer aus zwei Leistungshalbleitern gebildeten Halbbrücke ist, der zweite Typ ein Leistungshalbleitermodul mit einem einzelnen Leistungshalbleiter ist, welcher für den einen Brückenzweig einer Halbbrücke einsetzbar ist, und der dritte Typ ein Leistungshalbleitermodul mit einem einzelnen Leistungshalbleiter ist, welcher für den anderen Brückenzweig einer Halbbrücke einsetzbar ist, und wenn die Steueranschlüsse und die Steuersignalausgänge der Ansteuereinheiten in der ersten bzw. zweiten Konfiguration rotationssymmetrisch um eine Symmetrieachse angeordnet sind, und beim zweiten und dritten Typ von Leistungshalbleitermodul jeweils nur solche Steueranschlüsse belegt sind, dass die beim zweiten Typ belegten Steueranschlüsse durch Rotation um die Symmetrieachse um einen ausgewählten Symmetriewinkel in die beim dritten Typ belegten Steueranschlüsse übergehen, und wenn für beide Typen von Leistungshalbleitermodulen die gleiche Ansteuereinheit einsetzbar ist, welche beim zweiten Typ in einer ersten räumlichen Anordnung und beim dritten Typ in einer zweiten räumlichen Anordnung mit dem jeweiligen Leistungshalbleitermodul verbunden wird, wobei sich die beiden Anordnungen durch eine Rotation um die Symmetrieachse um den ausgewählten Symmetriewinkel unterscheiden. Hierdurch wird es möglich, zur Ansteuerung von zwei unterschiedlichen Modultypen die gleiche Ansteuereinheit zu verwenden, welche jeweils nur in einer anderen räumlichen Anordnung mit dem Modul verbunden wird.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
Fig. 1 in perspektivischer Darstellung ein bevorzugtes Ausführungsbeispiel für Bauform und Anordnung der Anschlüsse eines Leistungshalbleitermoduls nach der Erfindung;
Fig. 2 in verschiedenen Seitenansichten ein Modul gemäss Fig. 1 mit aufgeschraubter Ansteuereinheit;
Fig. 3 in schematisierter Darstellung ein bevorzugtes Ausführungsbeispiel eines Halbbrückenmoduls mit zwei Einzelhalbleitern und dem Anschlussschema auf der Ansteuer- und Leistungsseite;
Fig. 4 in schematisierter Darstellung ein bevorzugtes Ausführungsbeispiel eines Moduls mit Einzelhalbleiter für den einen Zweig einer Halbbrücke sowie das zugehörige Anschlussschema auf der Ansteuer- und Leistungsseite; und
Fig. 5 in schematisierter Darstellung ein bevorzugtes Ausführungsbeispiel eines Moduls mit Einzelhalbleiter für den anderen Zweig einer Halbbrücke sowie das zugehörige Anschlussschema auf der Ansteuer- und Leistungsseite.

### WEGE ZUR AUSFÜHRUNG DER ERFINDUNG

In Fig. 1 ist in perspektivischer Darstellung ein bevorzugtes Ausführungsbeispiel für Bauform und Anordnung der Anschlüsse eines Leistungshalbleitermoduls nach der Erfindung wiedergegeben. Das Leistungshalbleitermodul 10 ist in einem flachen, hüllenartigen, aus elektrisch isolierendem Kunststoff bestehenden Modulgehäuse 11 untergebracht. Für den internen Aufbau wird als Beispiel auf den eingangs genannten Artikel verwiesen. Das Modulgehäuse 11 kann mittels am Umfang verteilt angeordneter Befestigungslöcher 12a-g auf einer geeigneten Unterlage befestigt werden. Auf der Oberseite des Moduls sind sämtliche Anschlüsse für die elektrische Verbindung der internen Leistungshalbleiter mit einer externen Schaltung vorgesehen. Die Anschlüsse umfassen eine Mehrzahl von Leistungsanschlüssen 13 bis 17, die jeweils aus 3 untereinander verbundenen, aus den Gehäuse 11 nach oben herausgeführten und parallel zur Gehäuseoberfläche abgebogenen Anschlussfahnen bestehen. Unterhalb der Anschlussfahnen sind jeweils Kontermuttern eingelassen, in welche durch ein in den Fahnen vorgesehenes Rundloch eine Anschlussschraube eingeschraubt werden kann.

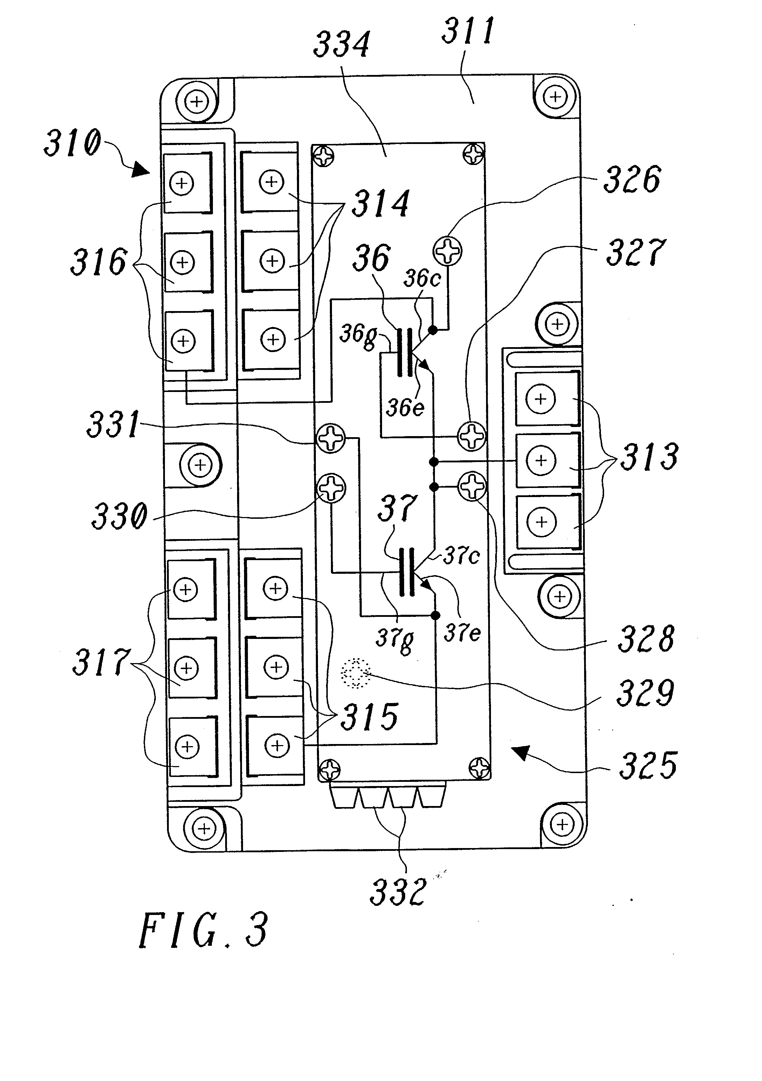

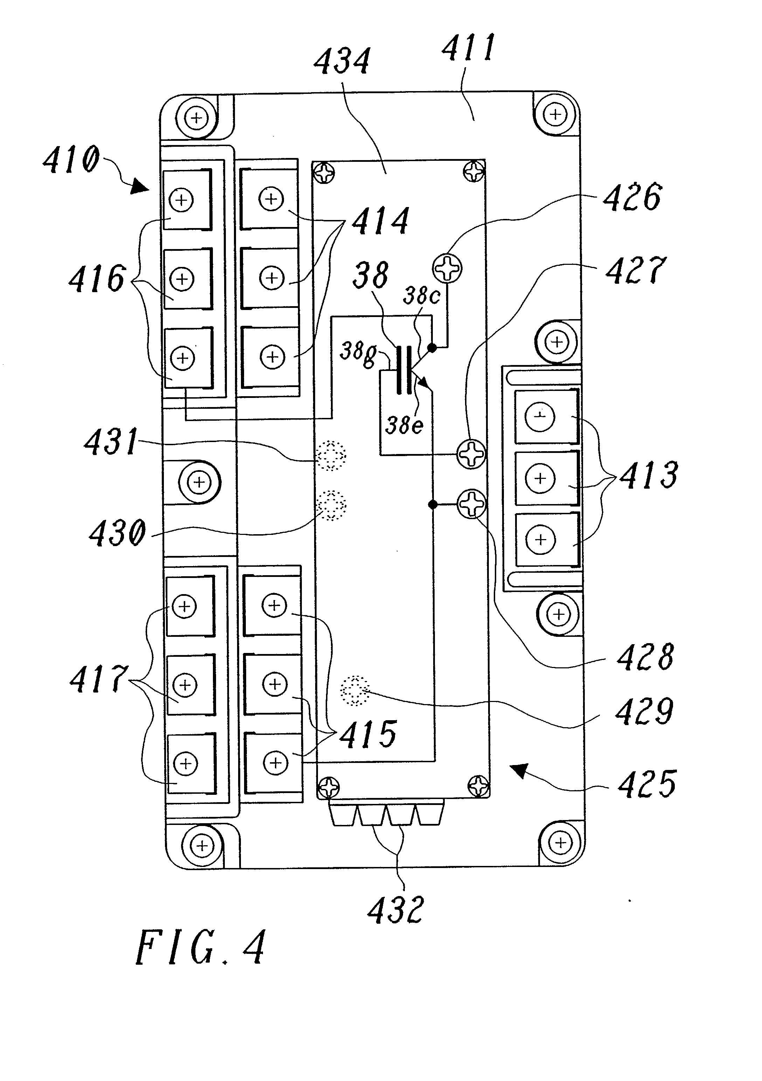

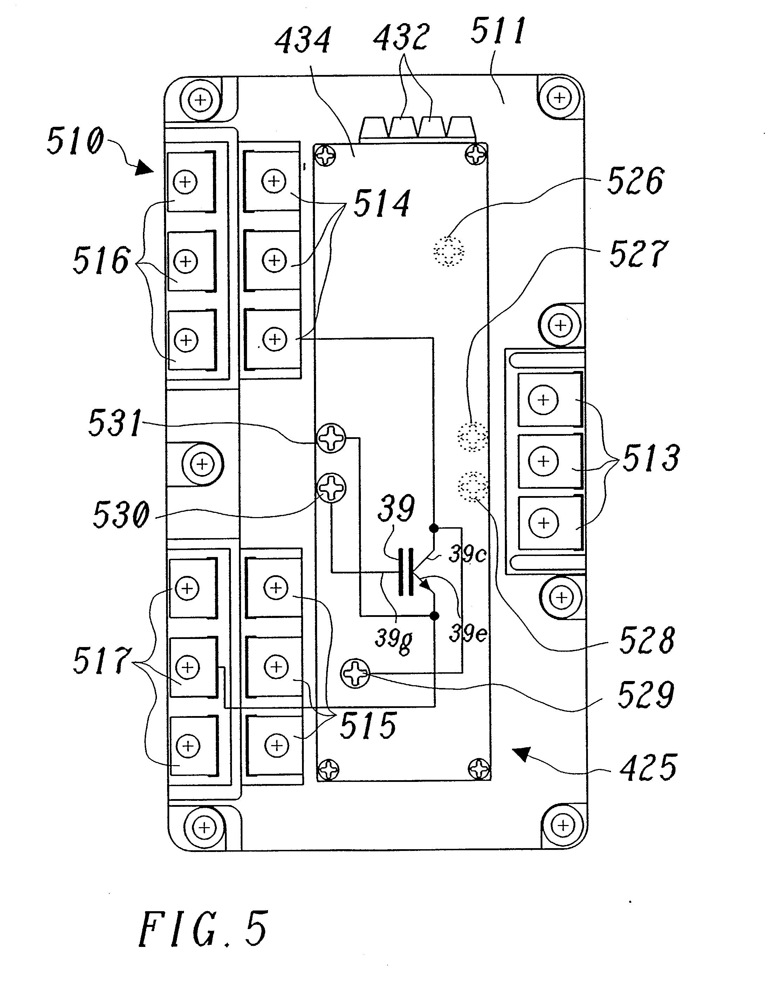

Der Leistungsanschluss 13 ist im Falle eines Moduls mit interner Halbbrücke mit dem Phasenausgang (Mittelabgriff) der Halbbrücke belegt (vgl. den Leistungsanschluss 313 in Fig. 3). Ist das Leistungshalbleitermodul 10 intern nur mit einem Einzelhalbleiter bestückt, ist der Leistungsanschluss 13 nicht belegt und damit funktionslos (vgl. Leistungsanschlüsse 413 und 513 in Fig. 4 bzw. Fig. 5). Die Leistungsanschlüsse 14 und 15 bzw. 16 und 17 sind jeweils untereinander verbunden und bilden jeweils auf unterschiedlichen Ebenen des Moduls einen 6-fach-Anschluss. An jeden 6-fach-Anschluss ist je nach internem Aufbau des Moduls die positiv oder negativ gepolte Elektrode eines Leistungshalbleiters, in Falle von IGBTs der Kollektor oder der Emitter, angeschlossen. Das im Rahmen der Erfindung bevorzugte Anschlussschema wird später im Zusammenhang mit den Fig. 3, 4 und 5 noch näher erläutert.

Im Mittelbereich des Moduls 10 zwischen den Leistungsanschlüssen 13 einerseits und den Leistungsanschlüssen 14, 15 andererseits sind in einer vorbestimmten ersten Konfiguration untereinander isoliert Steueranschlüsse 19 bis 24 angeordnet, die ebenfalls durch Einschrauben von Anschlussschrauben (z.B. 26 bis 31 in Fig. 2) in entsprechende Muttern kontaktiert werden können. Die Steueranschlüsse 19 bis 24 liegen innerhalb eines durch vier Gewindepfosten 18a-d definierten Rechtecks. Mittels der Gewindepfosten 18a-d kann gemäss Fig. 2 auf das Leistungshalbleitermodul 10 eine kompakte, in einem separaten Gehäuse 34 untergebrachte Ansteuereinheit 25 aufgeschraubt werden. Die entsprechenden Befestigungsschrauben 33a-d sind in der Draufsicht der Fig. 2(a) erkennbar. Auf der dem Modul zugewandten Unterseite der Ansteuereinheit 25 sind (in den Figuren nicht sichtbare) Steuersignalausgänge vorgesehen, die - von oben gesehen - in der gleichen Konfiguration angeordnet sind, wie die Steueranschlüsse 19 bis 24 auf der Oberseite des Leistungshalbleitermoduls 10. Jedem der Steueranschlüsse 19 bis 24 ist grundsätzlich ein Steuersignalausgang zugeordnet, der beim Aufsetzen der Ansteuereinheit 25 auf das Modul 10 über dem zugehörigen Steueranschluss zu liegen kommt und mittels einer von oben durch die Ansteuereinheit 25 hindurch in den Steueranschluss eingeschraubten Anschlussschraube 26 (für Steueranschluss 19) bis 31 (für Steueranschluss 24) mit dem Steueranschluss elektrisch verbunden wird. Seitlich an der Ansteuereinheit 25 sind mehrere (faseroptische) Steuersignalanschlüsse sowie ein DC-Versorgungsanschluss 35 (Fig. 2(c)) für die Elektronik der Ansteuereinheit 25 angeordnet. Ueber die Steuersignalanschlüsse 32 werden aus Lichtleitfasern die logischen Steuerbefehle auf die Ansteuereinheit 25 gegeben und dort zu Steuersignalen (Gatesignalen) für die im Modul eingebauten Leistungshalbleiter verarbeitet.

Die insgesamt 6 Steueranschlüsse 19 bis 24 (Fig. 1) bzw. die zugehörigen Anschlussschrauben 26 bis 31 (Fig. 2(a)) sind rotationssymmetrisch um eine Symmetrieachse (40 in Fig. 2(a)) herum plaziert. Der Symmetriewinkel beträgt dabei 180°. Wird die Konfiguration der Steueranschlüsse 19 bis 24 bzw. der Anschlussschrauben 26 bis 31 um diese Symmetrieachse 40 um 180° gedreht, nimmt der Steueranschluss 19 exakt die Position des Steueranschlusses 22 ein, der Steueranschluss 20 die Position des Steueranschlusses 23, und der Steueranschluss 21 die Position des Steueranschlusses 24, und umgekehrt. Dasselbe gilt sinngemäss für die Anschlussschrauben 26 bis 31, und für die (nicht sichtbaren) Steuersignalausgänge auf der Unterseite der Ansteuereinheit 25. Es ist also festzuhalten, dass, wenn die Ansteuereinheit 25 auf dem Modul 10 um die Symmetrieachse 40 um 180° gedreht wird, die Steuersignalausgänge wiederum über den Steueranschlüssen 19 bis 24 zu liegen kommen, mit dem Unterschied, dass die Zuordnung zwischen Steuersignalausgängen und Steueranschlüssen zyklisch vertauscht ist. Diese zyklische Vertauschung spielt eine wesentliche Rolle, wenn für unterschiedliche Module mit Einzelhalbleiter (Fig. 4 und 5) die gleiche Ansteuereinheit Verwendung finden soll.

In Fig. 3 ist das Anschlussschema für ein bevorzugtes Ausführungsbeispiel eines erfindungsgemässen Moduls mit zwei Leistungshalbleitern in Halbbrückenanordnung wiedergegeben. Das Leistungshalbleitermodul 310 hat mit dem Modulgehäuse 311 und den Leistungsanschlüssen 313 bis 317 dieselbe Bauform und Anschlusskonfiguration wie das Modul 10 aus Fig. 1,2. Die Steueranschlüsse, die den Steueranschlüssen 19 bis 24 des Moduls 10 aus Fig. 1 entsprechen, sind durch die aufgesetzte Ansteuereinheit 325 mit ihrem Gehäuse 334 und den Steuersignalanschlüssen 332 verdeckt. Als Leistungshalbleiter sind innerhalb des Moduls 310 zwei IGBTs (Insulated Gate Bipolar Transistors) 36 und 37 vorgesehen und mit ihren Anschlüssen in Form eines Schaltschemas eingezeichnet. Die IGBTs 36 und 37 haben jeweils ein Gate 36g, 37g, einen Kollektor 36c, 37c, und einen Emitter 36e, 37e. Da die Steueranschlüsse selbst verdeckt sind, sind die IGBTs 36 und 37 in der Fig. 3 symbolisch an die zugehörigen Anschlussschrauben 326 bis 331 angeschlossen, welche in die Steueranschlüsse (19-24 in Fig. 1) eingeschraubt sind und die Verbindung zur Ansteuereinheit herstellen. Die Anschlussschraube 326 entspricht dabei dem Steueranschluss 19 aus Fig. 1, die Anschlussschraube 327 dem Steueranschluss 20, usw..

Die IGBTs 36 und 37 sind innerhalb des Leistungshalbleitermoduls 310 zu einer Halbbrücke zusammengeschaltet. Dazu ist der Emitter 36e des ersten (oberen) IGBT mit dem Kollektor 37c des zweiten (unteren) IGBT verbunden. Die Verbindung zwischen dem ersten Emitter 36e und dem zweiten Kollektor 37c ist an den Leistungsanschluss 313 angeschlossen, der den Phasenausgang der Halbbrücke bildet. Die Verbindung ist zugleich an den Steueranschluss angeschlossen, welchem die Anschlussschraube 328 zugeordnet ist (21 in Fig. 1). Dieser Steueranschluss bildet einen Hilfsemitter bezüglich des ersten IGBT 36 und gleichzeitig einen Hilfskollektor bezüglich des zweiten IGBT 37. Der Kollektor 36c des ersten IGBT 36 ist an die Leistungsanschlüsse 316, 317 angeschlossen, welche den "+"-Anschluss der Halbbrücke 36, 37 bilden. Der Emitter 37e des zweiten IGBT 37 ist an die Leistungsanschlüsse 314, 315 angeschlossen, die den "-"-Anschluss der Halbbrücke bilden. Der Kollektor 36c des ersten IGBT 36 ist weiterhin mit dem Steueranschluss verbunden, welchem die Anschlussschraube 326 zugeordnet ist (19 in Fig. 1). Dieser Steueranschluss bildet einen Hilfskollektor bezüglich des ersten IGBT 36. Entsprechend ist der Emitter 37e des zweiten IGBT 37 zusätzlich an den Steueranschluss angeschlossen, dem die Anschlussschraube 331 zugeordnet ist (24 in Fig. 1). Dieser Steueranschluss bildet einen Hilfsemitter bezüglich des zweiten IGBT 37. Schliesslich sind die Gates 36g und 37g der beiden IGBTs jeweils mit einen Steueranschluss verbunden, dem die Anschlussschraube 327 bzw. 330 zugeordnet ist (20 bzw. 23 in Fig. 1).

Wenn man die Gateanschlüsse zu den Hilfsanschlüssen dazurechnet, hat die Halbbrücke des Leistungshalbleitermoduls 310 aus Fig. 3 also insgesamt drei Hauptanschlüsse 316, 317 bzw. 313 bzw. 314, 315 und fünf Hilfsanschlüsse (Anschlussschrauben 326, 327, 328, 330 und 331). Die Hilfsanschlüsse sind über die Anschlussschrauben an die Ansteuereinheit 325 angeschlossen. Der Anschluss, welcher der Anschlussschraube 329 zugeordnet ist (22 in Fig. 1), bleibt unbelegt, weil zwei Hilfsanschlüsse, nämlich der Hilfsemitter des ersten IGBT 36 und der Hilfskollektor des zweiten IGBT 37 gemeinsam über die eine Anschlussschraube 328 angeschlossen sind.

Mit derselben Bauform von Leistungshalbleitermodul und Ansteuereinheit können nun auf einfache Weise auch andere Modularten verwirklicht werden. Dies sind insbesondere die in Fig. 4 und 5 dargestellten Leistungshalbleitermodule 410 und 510 mit jeweils einem Einzelhalbleiter, die durch äussere Verschaltung der Module leicht zu einer Halbbrücke zusammengeschaltet werden können. Das Modul aus Fig. 4 bildet dabei ein sogenanntes Plus-Modul, d.h., ein Modul, welches die obere Hälfte einer Halbbrücke gemäss Fig. 3 darstellt. Das Modul aus Fig. 5 ist entsprechend ein Minus-Modul und wird zur Realisierung der unteren Hälfte einer Halbbrücke gemäss Fig. 3 verwendet.

Das Plus-Modul (Leistungshalbleitermodul 410) aus Fig. 4 enthält in einem Modulgehäuse 411, welches von der Bauform her identisch ist mit dem Modulgehäuse 311 aus Fig. 3, einen einzelnen IGBT 38, der in derselben Weise wie der erste IGBT 36 aus Fig. 3 mit seinem Kollektor 38c an die Leistungsanschlüsse 416, 417 angeschlossen ist. Der Emitter 38e ist mit den Leistungsanschlüssen 414, 415 verbunden, die den Leistungsanschlüssen 314, 315 aus Fig. 3 entsprechen. Die Leistungsanschlüsse 413 sind nicht belegt und können daher weggelassen werden.

Die Ansteuereinheit 425 mit dem Gehäuse 434 und den Steuersignalanschlüssen 432 weist dieselbe Bauform auf, wie die Ansteuereinheit 325 aus Fig. 3. Grundsätzlich sind auch bei der Ansteuereinheit 425 durch Anschlussschrauben 426 bis 431 sechs Hilfsanschlüsse anschliessbar, welche dieselbe räumliche Konfiguration einnehmen, wie die Steueranschlüsse 19 bis 24 in Fig. 1 bzw. die Anschlussschrauben 326 bis 331 in Fig. 3. Weil im vorliegenden Fall jedoch nur ein Einzelhalbleiter anzusteuern ist, bleiben die den (punktiert gezeichneten) Anschlussschrauben 429, 430 und 431 entsprechenden Steueranschlüsse im Modul 410 unbelegt und in der Ansteuereinheit 425 unberücksichtigt, d.h., die Ansteuereinheit 410 für den Einzelhalbleiter wird in der gleichen Bauform wie die Ansteuereinheit 310 für die Halbbrücke hergestellt, jedoch werden die Komponenten des unteren Zweiges nicht bestückt. In Uebereinstimmung mit Fig. 3 wird so als Hilfskollektor eine Verbindung vom Kollektor 38c des IGBT 38 zum Steueranschluss der Anschlussschraube 426, als Hilfsemitter eine Verbindung vom Emitter 38e zum Steueranschluss der Anschlussschraube 428, und als Gateanschluss eine Verbindung vom Gate 38g zum Steueranschluss der Anschlussschraube 427 gezogen.

Eine analoge Situation ergibt sich für das in Fig. 5 wiedergegebene Minus-Modul (Leistungshalbleitermodul 510). Auch hier ist als Einzelhalbleiter ein IGBT 39 in einem Leistungshalbleitermodul 510 eingesetzt, welches mit seinem Modulgehäuse 511 und den Leistungsanschlüssen 513 bis 516 von der Bauform her mit den Modulen aus Fig. 3 und 4 identisch ist. Der IGBT 39 ist mit seinem Kollektor 39c an die Leistungsanschlüsse 514, 515 und mit seinem Emitter 39e an die Leistungsanschlüsse 516, 517 angeschlossen. Da die Leistungsanschlüsse 514, 515 und 516, 517 - wie aus Fig. 1 zu entnehmen ist, auf unterschiedlichen Ebenen des Moduls liegen, kann durch diese Anschlusskonfiguration der Kollektor 39c eines Moduls gemäss Fig. 5 auf der gleichen Ebene sehr einfach mit dem Emitter 38e eines Moduls gemäss Fig. 4 verbunden werden, um eine komplette Halbbrücke zu bilden. Die Leistungsanschlüsse 513 sind auch hier nicht belegt und können daher weggelassen werden. Auf der Ansteuerseite ist der IGBT 39 in ähnlicher Weise wie der zweite IGBT 37 aus Fig. 3 angeschlossen: Der Emitter 39e ist als Hilfsemitter mit dem Steueranschluss zu Anschlussschraube 531 verbunden und das Gate 39g liegt am Steueranschluss zur Anschlussschraube 530. Zur Bildung eines Hilfskollektors ist in diesem Fall abweichend zu Fig. 3 der Kollektor 39c mit dem Steueranschluss zur Anschlussschraube 529 verbunden.

Die Besonderheit bei den beiden Einzelhalbleiter-Modulen 410 und 510 liegt nun darin, dass aufgrund der rotationssymmetrischen Anordnung der Steueranschlüsse bzw. Anschlussschrauben 426-431 bzw. 526-531 für beide Modularten dieselbe Ansteuereinheit 425 in unterschiedlicher räumlicher Anordnung verwendet werden kann. Im Falle des Leistungshalbleitermoduls 410 der Fig. 4 (Plus-Modul) wird die Ansteuereinheit 425 so orientiert und auf das Modul draufgeschraubt, dass die in der Ansteuereinheit intern belegten Steuersignalausgänge mittels der Anschlussschrauben 426, 427 und 428 an den Hilfskollektor (38c), das Gate 38g, und den Hilfsemitter (38e) des IGBT 38 angeschlossen werden können. Die Steuersignalanschlüsse 432 kommen dabei unten zu liegen.

Im Fall des Leistungshalbleitermoduls 510 aus Fig. 5 (Minus-Modul) wird die Ansteuereinheit 425 um 180° gedreht auf das Modul draufgeschraubt, so dass dieselben in der Ansteuereinheit intern belegten Steuersignalausgänge mittels der Anschlussschrauben 529, 430 und 430 in analoger Weise an den Hilfskollektor (39c), das Gate 39g, und den Hilfsemitter (39e) des IGBT 38 angeschlossen werden können. Die Steuersignalanschlüsse 432 kommen dabei oben zu liegen. Auf diese Weise wird im Rahmen der Erfindung ein System von Leistungshalbleitermodulen mit zugehörigen Ansteuereinheiten für den Aufbau von Halbleiterbrücken geschaffen, die sich durch eine einheitliche, normierte Bauform auszeichnen, leicht miteinander zu kombinieren sind und mit einer geringen Anzahl unterschiedlicher Ansteuereinheiten auskommen.

### BEZEICHNUNGSLISTE

- 10,310,410,510: Leistungshalbleitermodul
- 11,311,411,511: Modulgehäuse
- 12a-g: Befestigungsloch
- 13-17: Leistungsanschluss
- 18a-d: Gewindepfosten
- 19-24: Steueranschluss
- 25,325,425: Ansteuereinheit
- 26-31: Anschlussschraube
- 32,332,432: Steuersignalanschluss
- 33a-d: Befestigungsschraube (Ansteuereinheit)
- 34,334,434: Gehäuse (Ansteuereinheit)
- 35: Versorgungsanschluss
- 36,37: IGBT (Halbbrücke)
- 36c,37c: Kollektor
- 36e,37e: Emitter
- 36g,37g: Gate
- 38,39: IGBT (einzeln)
- 38c,39c: Kollektor
- 38e,39e: Emitter
- 38g,39g: Gate
- 40: Symmetrieachse
- 313-317: Leistungsanschluss
- 326-331: Anschlussschraube
- 413-417: Leistungsanschluss
- 426-431: Anschlussschraube
- 513-517: Leistungsanschluss
- 526-531: Anschlussschraube

## Patentansprüche

1. Leistungshalbleitermodul-System, umfassend eine Mehrzahl von Typen von Leistungshalbleitermodulen (10, 310, 410, 510), welche jeweils einen oder mehrere steuerbare Leistungshalbleiter (36, 37, 38, 39) enthalten und jeweils in einem Modulgehäuse (11, 311, 411, 511) mit nach aussen geführten Leistungsanschlüssen (13-17, 313-317, 413-417, 513-517) und Steueranschlüssen (19-24) untergebracht sind, sowie zu jedem der Leistungshalbleitermodule (10, 310, 410, 510) eine in einem separaten Gehäuse (34, 334, 434) untergebrachte Ansteuereinheit (25, 325, 425), welche mit dem zugehörigen Leistungshalbleitermodul derart lösbar verbunden werden kann, dass die von der Ansteuereinheit (25, 325, 425) an entsprechenden Steuersignalausgängen abgegebenen Ansteuersignale auf die entsprechenden Steueranschlüsse (19-24) des Leistungshalbleitermoduls gelangen, wobei die Steueranschlüsse (19-24) der Leistungshalbleitermodule (10, 310, 410, 510) jeweils in einer ersten ortsfesten räumlichen Konfiguration angeordnet sind, und die Steuersignalausgänge der Ansteuereinheiten (25, 325, 425) jeweils in einer zweiten ortsfesten räumlichen Konfiguration angeordnet sind, die zur ersten Konfiguration deckungsgleich ist, dadurch gekennzeichnet, dass die ersten und zweiten Konfigurationen für alle Leistungshalbleitermodule (10, 310, 410, 510) bzw. Ansteuereinheiten (25, 325, 425) gleich sind, und dass sich die verschiedenen Leistungshalbleitermodule (10, 310, 410, 510) bzw. Ansteuereinheiten (25, 325, 425) durch eine unterschiedliche Belegung der Steueranschlüsse (19-24) bzw. Steuersignalausgänge unterscheiden.

2. Leistungshalbleitermodul-System nach Anspruch 1, dadurch gekennzeichnet, dass die Modulgehäuse (11, 311, 411, 511) und die Gehäuse (34, 334, 434) der Ansteuereinheiten (25, 325, 425) jeweils für alle Leistungshalbleitermodule (10, 310, 410, 510) bzw. Ansteuereinheiten (25, 325, 425) gleich sind.

3. Leistungshalbleitermodul-System nach Anspruch 2, dadurch gekennzeichnet, dass die Leistungsanschlüsse (13-17, 313-317, 413-417, 513-517) der Leistungshalbleitermodule (10, 310, 410, 510) jeweils in einer dritten ortsfesten räumlichen Konfiguration angeordnet sind, dass die dritte Konfiguration für alle Leistungshalbleitermodule (10, 310, 410, 510) gleich ist, und dass sich die verschiedenen Leistungshalbleitermodule (10, 310, 410, 510) durch eine unterschiedliche Belegung der Leistungsanschlüsse (13-17, 313-317, 413-417, 513-517) unterscheiden.

4. Leistungshalbleitermodul-System nach einem der Ansprüche 1 bis 3, dadurch gekennzeichnet, dass das System wenigstens drei Typen von Leistungshalbleitermodulen umfasst, welche insbesondere zum Aufbau von Brückenschaltungen geeignet sind, wobei der erste Typ ein Leistungshalbleitermodul (310) mit einer aus zwei Leistungshalbleitern (36, 37) gebildeten Halbbrücke ist, der zweite Typ ein Leistungshalbleitermodul (410) mit einem einzelnen Leistungshalbleiter (38) ist, welcher für den einen Brückenzweig einer Halbbrücke einsetzbar ist, und der dritte Typ ein Leistungshalbleitermodul (510) mit einem einzelnen Leistungshalbleiter (39) ist, welcher für den anderen Brückenzweig einer Halbbrücke einsetzbar ist.

5. Leistungshalbleitermodul-System nach Anspruch 4, dadurch gekennzeichnet, dass die Steueranschlüsse (19-24) und die Steuersignalausgänge der Ansteuereinheiten (25, 325, 425) in der ersten bzw. zweiten Konfiguration rotationssymmetrisch um eine Symmetrieachse (40) angeordnet sind, dass beim zweiten und dritten Typ von Leistungshalbleitermodul (410 bzw. 510) jeweils nur solche Steueranschlüsse belegt sind, dass die beim zweiten Typ (410) belegten Steueranschlüsse durch Rotation um die Symmetrieachse (40) um einen ausgewählten Symmetriewinkel in die beim dritten Typ (510) belegten Steueranschlüsse übergehen, und dass für beide Typen von Leistungshalbleitermodulen (410, 510) die gleiche Ansteuereinheit (425) einsetzbar ist, welche beim zweiten Typ (410) in einer ersten räumlichen Anordnung und beim dritten Typ (510) in einer zweiten räumlichen Anordnung mit dem jeweiligen Leistungshalbleitermodul (410 bzw. 510) verbunden wird, wobei sich die beiden Anordnungen durch eine Rotation um die Symmetrieachse (40) um den ausgewählten Symmetriewinkel unterscheiden.

6. Leistungshalbleitermodul-System nach Anspruch 5, dadurch gekennzeichnet, dass der ausgewählte Symmetriewinkel 180° beträgt.

7. Leistungshalbleitermodul-System nach einem der Ansprüche 1 bis 6, dadurch gekennzeichnet, dass die Steueranschlüsse (19-24) der Leistungshalbleitermodule (10, 310, 410, 510) und die Steuersignalausgänge der Ansteuereinheiten (25, 325, 425) jeweils durch Schraubanschlüsse (326-331, 426-431, 526-531) miteinander elektrisch verbindbar sind.

8. Leistungshalbleitermodul-System nach einem der Ansprüche 1 bis 7, dadurch gekennzeichnet, dass die steuerbaren Leistungshalbleiter als IGBTs (36, 37, 38, 39) ausgebildet sind.
